# EUROPÄISCHE PATENTSCHRIFT

(11) **EP 2 997 645 B1**
(45) Veröffentlichungstag und Bekanntmachung des Hinweises auf die Patenterteilung: **01.08.2018**
(21) Anmeldenummer: 14708899.1
(22) Anmeldetag: 11.03.2014
(51) Int. Cl.: H02K 5/14, H02K 11/026, H02K 11/38, H02K 5/22

(54) **KONTAKTIERUNGSKOMPONENTE FÜR EIN ANTRIEBSMODUL, ANTRIEBSMODUL SOWIE VERFAHREN ZUR HERSTELLUNG EINER KONTAKTIERUNGSKOMPONENTE**
CONTACTING PART FOR A DRIVE MODULE, DRIVE MODULE, AND METHOD FOR PRODUCING A CONTACTING PART
PIÈCE DE CONTACT POUR UN MODULE D'ENTRAÎNEMENT, MODULE D'ENTRAÎNEMENT AINSI QUE PROCÉDÉ DE FABRICATION D'UNE PIÈCE DE CONTACT

(30) Priorität: 17.05.2013 DE 102013209233
(43) Veröffentlichungstag der Anmeldung: 23.03.2016
(73) Patentinhaber: Robert Bosch GmbH, 70442 Stuttgart (DE)
(72) Erfinder: MAERKLE, Jens, 77815 Buehl (DE)
(86) Internationale Anmeldenummer: PCT/EP2014/054653
(87) Internationale Veröffentlichungsnummer: WO 2014/183899

(56) Entgegenhaltungen:
- EP-A1- 1 351 368
- EP-A2- 1 261 108
- WO-A1-01/59915
- WO-A1-01/80407
- DE-A1-102004 059 912
- DE-A1-102006 055 159
- DE-C1- 19 858 232
- JP-A- 2010 173 466
- US-A1- 2005 285 463
- US-A1- 2009 251 030

## Beschreibung

### Technisches Gebiet

Die vorliegende Erfindung betrifft Antriebsmodule, insbesondere Antriebsmodule mit Elektromotoren. Die Erfindung betrifft weiterhin insbesondere die Anordnung von EMV-Bauelementen und/oder Sensoren zur Rotorlageerfassung in elektrischen Maschinen für Antriebsmodule.

### Stand der Technik

Elektromotoren in Antriebsmodulen, wie beispielsweise Fensterheber-Antriebsmodulen in Kraftfahrzeugen, können als bürstenkommutierte Gleichstrommotoren vorgesehen sein. Derartige Elektromotoren sind mit Bürstenträgern versehen, die Bürsten zur elektrischen Kommutierung des Elektromotors halten. Die Bürsten stehen üblicherweise über ein Stanzgitter mit einem externen Steckeranschluss in elektrischer Verbindung.

Zur Reduzierung von EMV-Störsignalen auf den Zuleitungen sind EMV-Bauelemente und/oder Sensoren für eine Rotorlageerfassung elektrisch an Stanzgitterleitungen des Stanzgitters angeschlossen. Die EMV-Bauelemente und/oder -Sensoren können als bedrahtete Bauelemente vorgesehen sein, die durch einen Schweiß- oder Lötprozess mit den Stanzgitterleitungen verbunden werden.

Zur Einsparung von Bauraum können die bedrahteten Bauelemente durch SMD-Bauelemente ersetzt werden, die entweder direkt mit den Stanzgitterleitungen verbunden werden oder auf eine geeignete Leiterplatte aufgesetzt sind, die elektrisch mit den Stanzgitterleitungen verbunden wird. Das elektrische Kontaktieren von SMD-Bauelementen gestaltet sich jedoch in der Praxis häufig aufwändig.

Elektrische Maschinen für Antriebsmodule werden in der Regel mit einem Poltopfgehäuse und einer stirnseitig darauf aufgesetzten Kontaktierungskomponente versehen, die Bürstenträger zur Aufnahme von Bürsten bereitstellt, über die der Läufer der elektrischen Maschine elektrisch kontaktiert werden kann. Die Kontaktierungskomponente weist weiterhin Stanzgitterleitungen auf, die an einem Steckeranschluss enden, wobei zwischen dem Steckeranschluss und den Bürsten eine Schaltung aus SMD-Bauelementen und/oder einem oder mehreren Sensoren für eine Rotorlageerkennung angeordnet ist. Die Anordnung der Bauelemente vergrößert den benötigten Bauraum und beeinflusst damit die Gesamtgröße eines Antriebsmoduls, in dem das Bürstenträgerelement eingesetzt ist.

Es ist Aufgabe der vorliegenden Erfindung, eine Kontaktierungskomponente für ein Antriebsmodul zur Verfügung zu stellen, die der Aufnahme von Bürstenträgern und deren elektrischer Kontaktierung dient. Weiterhin soll die Kontaktierungskomponente in raumsparender Weise mit elektrischen Bauelementen, insbesondere EMV-Bauelementen und/oder einem oder mehreren Sensorbauelementen, versehen werden.

Mit der WO 01/80407 A1 ist ein Verstellantrieb bekannt geworden, bei dem an einer Innenseite eines Getriebegehäusedeckels Leiterbahnen zum elektrischen Verbinden von elektronischen Bauteilen mittels MID-Technik angeordnet sind. Die WO 01/59915 A1 beschreibt eine elektrische Antriebseinheit, bei der eine Bürstenbrücke zwischen einem Poltopf und einem Elektronikmodul angeordnet ist. Dabei ist die Bürstenbrücke mittels Kontaktierungselementen in Einstecktechnik mit einer Elektronikplatine des Elektronikmoduls verbunden. Der Stellantrieb gemäß der DE 10 2006 055 159 A1 weist ein Bürstensystem auf, das zumindest teilweise auf einer Leiterplatte angeordnet ist, die zumindest teilweise mit dem Kunststoff des Getriebegehäuses umsprizt ist.

Mit der US 2009/251030 A1 ist eine elektronisch kommutierte permanentmagneterregte Synchronmaschine bekannt geworden, bei der elektrische Verbindungselemente als Einlegeteile zwischen zwei Elektroniksubstraten eingegossen sind.

Die DE 10 2004 059 912 A1 offenbart eine elektrische Maschine umfassend einen Bürstenträger mit Flexfolie.

### Offenbarung der Erfindung

Diese Aufgabe wird durch die Kontaktierungskomponente für ein Antriebsmodul gemäß Anspruch 1, ein Verfahren gemäß Anspruch 10 sowie durch die elektrische Maschine und das Antriebsmodul gemäß den nebengeordneten Ansprüchen gelöst. Weitere vorteilhafte Ausgestaltungen der vorliegenden Erfindung sind in den abhängigen Ansprüchen angegeben.

Gemäß einem ersten Aspekt ist eine Kontaktierungskomponente für ein Antriebsmodul vorgesehen, umfassend:
- einen elektrisch nicht leitenden Grundkörper zum Bereitstellen einer Kontaktierung eines bürstenkommutierten Antriebsmotors über Bürsten;
- mindestens eine Zuleitung, insbesondere eine Stanzgitterleitung, zum elektrischen Kontaktieren des Antriebsmotors;
- eine Schaltungsfläche des Grundkörpers, auf der mittels einer MID-Technik eine Leiterbahn unmittelbar aufgebracht ist; und
- mindestens ein elektrisches Bauelement, insbesondere ein SMD-Bauelement, das elektrisch mit der Leiterbahn verbunden ist.

Eine Idee der obigen Kontaktierungskomponente besteht darin, den Grundkörper der Kontaktierungskomponente mit einer Schaltungsfläche vorzusehen, auf die unmittelbar eine Leiterbahn aufgebracht ist. Mit anderen Worten wird die Leiterbahn unmittelbar auf das nicht leitende Material, insbesondere das Kunststoffmaterial, des Grundkörpers der Kontaktierungskomponente aufgebracht. Auf diese Weise ist es möglich, sowohl auf bedrahtete Bauelemente als auch auf Leiterplatten zum Anschließen von SMD-Bauelementen zu verzichten und damit den für das Einbringen der Bauelemente benötigten Bauraum deutlich zu reduzieren.

Weiterhin ist es möglich, herkömmliche SMD-Bauelemente zum Aufbringen auf die auf der Fläche der Kontaktierungskomponente aufgebrachte Leiterbahn zu verwenden.

Darüber hinaus kann die Kontaktierungskomponente mit einer vereinfachten Geometrie vorgesehen werden, da Halterungen für Bauelemente bzw. Leiterplatten entfallen können. Die Kontaktierungskomponente wird häufig als Spritzgusskomponente hergestellt, wodurch der Aufwand für die Herstellung deutlich reduziert und weiterhin Kunststoffmaterial eingespart werden kann.

Zudem kann aufgrund der kürzeren Anbindungen von EMV-Bauelementen ein verbessertes EMV-Verhalten erreicht werden.

Weiterhin kann die mindestens eine Zuleitung zumindest abschnittsweise in einer Erstreckungsrichtung verlaufen, wobei die Schaltungsfläche quer zur Erstreckungsrichtung angeordnet ist.

Alternativ kann die mindestens eine Zuleitung zumindest abschnittsweise in einer Erstreckungsrichtung verlaufen, wobei die Schaltungsfläche parallel zur Erstreckungsrichtung angeordnet ist und wobei die Leiterbahn zur Kontaktierung der mindestens einen Zuleitung auf eine benachbarte Zuleitungsfläche geführt wird, die quer zur Erstreckungsrichtung angeordnet ist.

Gemäß einer Ausführungsform kann vorgesehen sein, dass das Bauelement mit der Leiterbahn und/oder die Leiterbahn mit der mindestens einen Zuleitung verbunden ist, indem ein leitfähiges Material, insbesondere ein leitfähiger Klebstoff oder ein Lotmaterial zwischen einen Kontakt des Bauelements und die Leiterbahn bzw. zwischen die mindestens eine Zuleitung und die Leiterbahn aufgebracht wird.

Es kann vorgesehen sein, dass ein Abschnitt der Zuleitung über eine Öffnung nahe einem Ende der zu kontaktierenden Leiterbahn zugänglich ist, wobei ein Abschnitt der Zuleitung die zu kontaktierende Leiterbahn durchdringt oder wobei ein Abschnitt der Zuleitung an einer Oberfläche der Kontaktierungskomponente geführt ist und die Leiterbahn an den Abschnitt der Zuleitung angrenzt.

Gemäß einem weiteren Aspekt ist ein Antriebsmodul vorgesehen, das einen Antriebsmotor und die obige Kontaktierungskomponente umfasst, die mit dem Antriebsmotor verbunden ist, um eine Kontaktierung des Antriebsmotors über die Zuleitungen bereitzustellen.

Weiterhin kann das Antriebsmodul in ein Gehäuse des Antriebsmotors eingesetzt sein.

An einer dem Antriebsmotor gegenüberliegenden Seite der Kontaktierungskomponente kann ein Getriebegehäuse angeordnet sein, wobei die Schaltungsfläche in das Getriebegehäuse hineinragt.

Gemäß einem weiteren Aspekt ist ein Verfahren zum Herstellen einer Kontaktierungskomponente für ein Antriebsmodul vorgesehen, das die folgenden Schritte umfasst:
- Bereitstellen eines nicht leitenden Grundkörpers, insbesondere aus einem Kunststoffmaterial, mit mindestens einer zumindest teilweise eingebetteten Zuleitung zum Bereitstellen einer Kontaktierung eines bürstenkommutierten Antriebsmotors;
- Aufbringen einer Leiterbahn unmittelbar auf eine Schaltungsfläche des Grundkörpers mittels einer MID-Technik; und
- elektrisches Kontaktieren mindestens eines elektrischen Bauelements, insbesondere eines SMD-Bauelements, über die Leiterbahn.

Weiterhin kann vorgesehen sein, dass das elektrische Kontaktieren des elektrischen Bauelements mithilfe eines aushärtenden leitfähigen Materials, insbesondere eines leitfähigen Klebstoffs, erfolgt.

Es kann vorgesehen sein, dass das elektrische Bauelement mithilfe eines aushärtenden leitfähigen Materials, insbesondere eines leitfähigen Klebstoffes, elektrisch kontaktiert wird.

Weiterhin kann die Leiterbahn durch eines der folgenden Verfahren auf die Schaltungsfläche aufgebracht werden:
- Bedrucken mit einer Folie aus einem leitfähigen Material unter Verwendung eines Heißprägestempel, der die Strukturen der Leiterbahn als Prägeflächen abbildet, so dass der mit dem Heißprägestempel beaufschlagte Bereich der Folie mit dem Material des Grundkörpers verschmilzt und beim Abziehen der Folie an dem Grundkörper haften bleibt, während der übrige Bereich der Folie sich von der Schaltungsfläche löst;
- Besprühen der Schaltungsfläche durch eine Strukturierungsmaske mit leitfähigen Metallpartikeln, die haftend ausgebildet sind, so dass die Struktur der Leiterbahn entsprechend der Strukturierungsmaske auf der Schaltungsfläche ausgebildet wird; und
- Beschreiben der Schaltungsfläche mithilfe einer Laser-Direktstrukturierung entsprechend der Struktur der Leiterbahn, so dass das Material des Grundkörpers im Bereich der aufzubringenden Leiterbahn aktiviert wird, wobei die Leiterbahn durch galvanisches Metallisieren des aktivierten Bereichs hergestellt wird.

### Kurzbeschreibung der Zeichnungen

Bevorzugte Ausführungsformen der vorliegenden Erfindung werden nachfolgend anhand der beigefügten Zeichnungen näher erläutert. Es zeigen:
- Figur 1: eine Darstellung eines Antriebsmoduls mit einem Antriebsmotor und einem Getriebegehäuse, die über eine Kontaktierungskomponente miteinander verbunden sind;
- Figur 2: eine Darstellung einer Kontaktierungskomponente mit aufgebrachten Bauelementen;
- Figur 3: eine Darstellung der Kontaktierungskomponente aus einer weiteren Blickrichtung zur Darstellung der Bestückungsrichtung für die Bauelemente;
- Figur 4: eine detailliertere Darstellung der Schaltungsfläche und der Kontaktierung der Stanzgitterleitungen;
- Figur 5: eine Darstellung einer weiteren Kontaktierungskomponente mit aufgebrachten Bauelementen;
- Figuren 6a und 6b: eine perspektivische und Schnittdarstellung einer Kontaktierungsart zwischen einer Stanzgitterleitung und einer Leiterbahn auf der Schaltungsfläche;
- Figuren 7a und 7b: eine perspektivische und Schnittdarstellung einer weiteren Kontaktierungsart zwischen einer Stanzgitterleitung und einer Leiterbahn auf der Schaltungsfläche; und
- Figuren 8a und 8b: eine perspektivische und Schnittdarstellung einer weiteren Kontaktierungsart zwischen einer Stanzgitterleitung und einer Leiterbahn auf der Schaltungsfläche;

### Beschreibung von Ausführungsformen

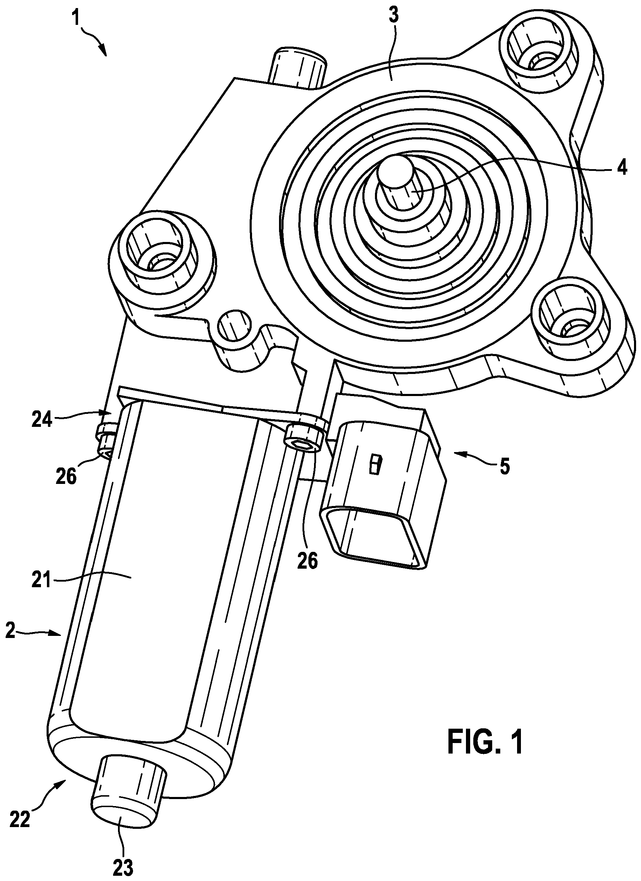

Figur 1 zeigt eine perspektivische Darstellung eines Antriebsmoduls 1 in Form eines Fensterhebermoduls zum Einsatz in Kraftfahrzeugen mit elektrischen Fensterhebern. Das Antriebsmodul 1 weist einen Antriebsmotor 2 auf, der an einem Getriebegehäuse 3 angeordnet ist. Aus dem Getriebegehäuse 3 ragt eine Abtriebswelle 4 zum Antrieb einer Mechanik, wie z.B. zum Heben oder Senken einer Fensterscheibe in einem elektrischen Fensterhebersystem eines Kraftfahrzeugs. Zwischen dem Getriebegehäuse 3 und dem Antriebsmotor 2 ist eine Kontaktierungskomponente 5 angeordnet, die den Antriebsmotor 2 und das Getriebegehäuse 3 mechanisch miteinander verbindet.

Der Antriebsmotor 2 ist in einem Polgehäuse 21 aufgenommen, das an einem ersten Ende 22 eine Lageraufnahme 23 zur gelagerten Aufnahme einer (nicht gezeigten) Motorwelle bereitstellt. An einem dem ersten Ende 22 gegenüberliegenden Ende 24 des Polgehäuses 21 ist die Kontaktierungskomponente 5 angeordnet.

Der Antriebsmotor 2 ist so ausgebildet, dass ein an der Motorwelle angeordneter Kommutator in die Kontaktierungskomponente 5 hineinragt und dort von in einem Bürstenträger gehaltenen Bürsten (nicht gezeigt) kontaktiert wird. Die Motorwelle durchdringt die Kontaktierungskomponente 5 und ragt in das Getriebegehäuse 3 hinein, wo sie beispielsweise mit einem Schneckenrad verbunden sein kann, um in ein entsprechendes in dem Getriebegehäuse 3 angeordnetes Getriebe einzugreifen.

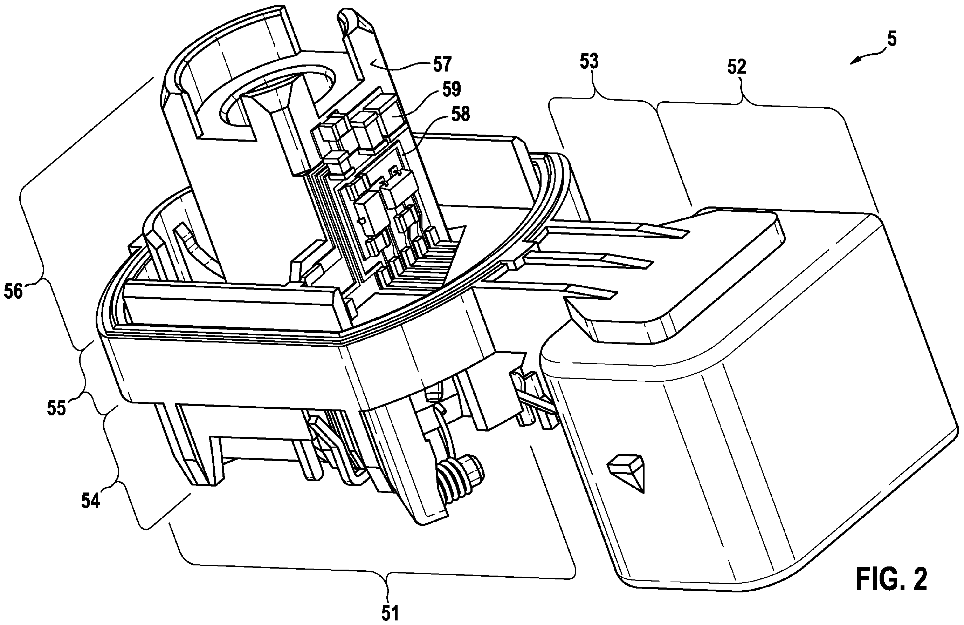

Die Kontaktierungskomponente 5 ist in Figur 2 separat dargestellt. Die Kontaktierungskomponente 5 weist einen Grundkörper auf, der vorzugsweise aus einem Kunststoffmaterial als Spritzgußbauteil einstückig gefertigt ist.

Der Grundkörper weist einen Antriebsmodulabschnitt 51 und einen Steckverbinderabschnitt 52 auf, die über einen Verbindungsabschnitt 53 miteinander verbunden sind. Die Kontaktierungskomponente 5 ist vorzugsweise aus einem elektrisch nicht leitenden Material, wie beispielsweise einem Kunststoffmaterial, einstückig, beispielsweise in einem Spritzgussverfahren, hergestellt und dient dazu, eine Kontaktierung der Bürsten in dem Antriebsmodulabschnitt 51 über den Steckverbinder des Steckverbinderabschnitts 52 zu gewährleisten.

Der Steckverbinder des Steckverbinderabschnitt 52 enthält hervorstehende Kontaktstifte, die über einen geeigneten Steckeranschluss kontaktiert werden können. Die Kontaktstifte werden durch die Enden von Stanzgitterleitungen 62 eines Stanzgitters gebildet, die insbesondere in dem Verbindungsabschnitt 53 in dem Material der Kontaktierungskomponente 5 eingebettet sind. Das Stanzgitterleitungen 62 des Stanzgitters dienen als Zuleitungen für den Antriebsmotor 2.

Der Antriebsmodulabschnitt 51 weist einen ersten Halteabschnitt 54 mit Haltestrukturen auf, die in das zweite Ende 24 des Polgehäuses 21 eingesetzt werden, so dass die Kontaktierungskomponente 5 fest auf dem Polgehäuse 21 des Antriebsmotors 2 aufsitzt. Die Kontaktierungskomponente 5 und das Polgehäuse 21 können miteinander durch Verbindungselemente 26, wie z.B. Schrauben verbunden sein. In dem ersten Halteabschnitt 54 der Kontaktierungskomponente 5 sind die Bürsten in entsprechenden Bürstenträgern angeordnet, um den an der Rotorwelle des Antriebsmotors 2 befindlichen Kommutator elektrisch zu kontaktieren.

An den ersten Halteabschnitt 54 schließt sich eine Bürstenträgerbasis 55 des Grundkörpers der Kontaktierungskomponente 5 an. An der dem ersten Halteabschnitt 54 gegenüberliegenden Seite der Bürstenträgerbasis 55 ist ein zweiter Halteabschnitt 56 mit entsprechenden Haltestrukturen vorgesehen, die im montierten Zustand in das Getriebegehäuse 3 hineinragen und dadurch die Kontaktierungskomponente 5 mit dem Getriebegehäuse 3 verbinden.

Der zweite Halteabschnitt 56 des Grundkörpers weist eine Schaltungsfläche 57 auf, die insbesondere zur Achse der Motorwelle parallel und in Richtung des Verbindungsabschnitts 53 ausgerichtet sein kann. Alternativ kann die Schaltungsfläche 57 auch auf anderen Flächen, wie z.B. dem ersten Halteabschnitt oder der Bürstenträgerbasis 55 vorgesehen sein.

Auf die Schaltungsfläche 57 wird mithilfe einer geeigneten Technik eine Leiterbahn 58 direkt auf die Oberfläche des Materials des Grundkörpers der Kontaktierungskomponente 5 aufgebracht. Die Leiterbahn 58 kann beispielsweise aus Kupfer, Silber oder einem sonstigen leitfähigen Material ausgebildet sein. Die Leiterbahn 58 kann mithilfe verschiedener Verfahren auf das Material der Kontaktierungskomponente 5 aufgebracht werden.

Auf die Leiterbahn 58 werden mittels eines geeigneten Verfahrens SMD-Bauelemente 59 aufgebracht, beispielsweise mithilfe eines leitfähigen Klebers oder durch Löten, so dass die SMD-Bauelemente 59 zuverlässig an der Leiterbahn 58 gehalten sind und diese elektrisch kontaktieren. Die Bauelemente 59 können EMV-Bauelemente, wie beispielsweise Drosselinduktivitäten oder Kapazitäten, umfassen und darüber hinaus ein oder mehrere Sensorbauelemente, wie beispielsweise einen Hallsensor, aufweisen, der so an der Schaltungsfläche 57 angeordnet ist, dass er in einer Richtung senkrecht zur axialen Richtung der Motorwelle einem (nicht gezeigten) Ringmagneten an der (nicht gezeigten) Motorwelle gegenüberliegt. Die Leiterbahn 58 wird auf der Schaltungsfläche 57 als MID (*Molded Interconnect Device*) vorgesehen.

In einem ersten Verfahren zum Aufbringen einer Leiterbahn kann die Schaltungsfläche 57 mit einer Folie aus einem elektrisch leitfähigen Material, wie beispielsweise einer Kupferfolie, bedruckt werden, und zwar unter Verwendung eines Heißprägestempels, der die Strukturen der Leiterbahn 58 als erwärmte Prägeflächen abbildet, so dass die mit dem Heißprägestempel beaufschlagten Bereiche der Folie mit dem Kunststoffmaterial der Schaltungsfläche 57 verschmelzen und beim Abziehen der Folie an dem Kunststoffmaterial haften bleiben, während die übrigen Bereiche der Metallfolie nicht mit der Schaltungsfläche 57 verbunden werden und sich von dieser lösen.

In einem weiteren Verfahren kann die Schaltungsfläche 57 über eine Maske mit leitfähigen Metallpartikeln besprüht werden, die in geeigneter Weise haftend ausgebildet sind. Beispielsweise kann ein Spray aus Silberpartikeln durch die Strukturierungsmaske auf die Schaltungsfläche 57 aufgesprüht werden, wobei das Verbinden der Metallpartikel mit dem Material der Schaltungsfläche 57 mittels eines geeigneten Klebstoffs, einer Temperatur oder einer ausreichend hohen Aufprallenergie erreicht werden kann. Alternativ oder zusätzlich kann dem Spray auch Lösungsmittel oder dergleichen zugesetzt sein, um die Metallpartikel dauerhaft mit dem Material der Kontaktierungskomponente 5 zu verbinden.

Mithilfe eines dritten Verfahrens kann die Schaltungsfläche 57 mittels einer Laser-Direktstrukturierung entsprechend der Strukturen der Leiterbahnen so beschrieben werden, dass das Material, insbesondere das Kunststoffmaterial, der Kontaktierungskomponente 5 aktiviert wird, um dann galvanisch metallisiert werden zu können. Dieser Prozess wird auch als chemisches Galvanisieren bezeichnet.

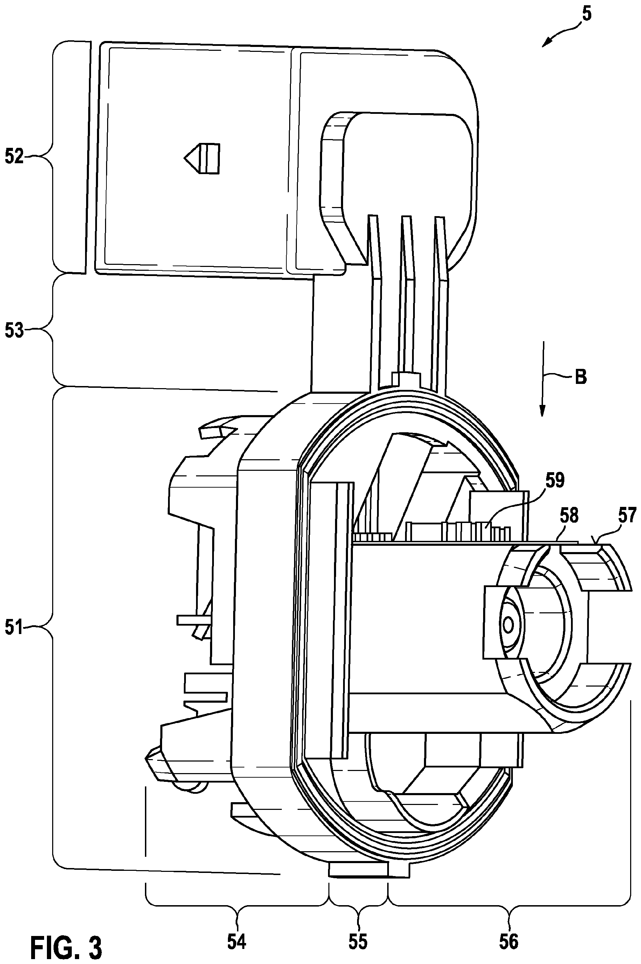

In Figur 3 ist eine weitere perspektivische Darstellung der Kontaktierungskomponente 5 gezeigt, und zwar in einer Betrachtungsrichtung parallel zur Erstreckung der Schaltungsfläche 57. Man erkennt die Bestückungsrichtung B als Richtung senkrecht zur Schaltungsfläche 57. In Richtung der Bestückungsrichtung B werden die SMD-Bauelemente 59 auf die Leiterbahn 58 aufgebracht und anschließend mit dem leitfähigen Klebstoff fixiert oder angelötet.

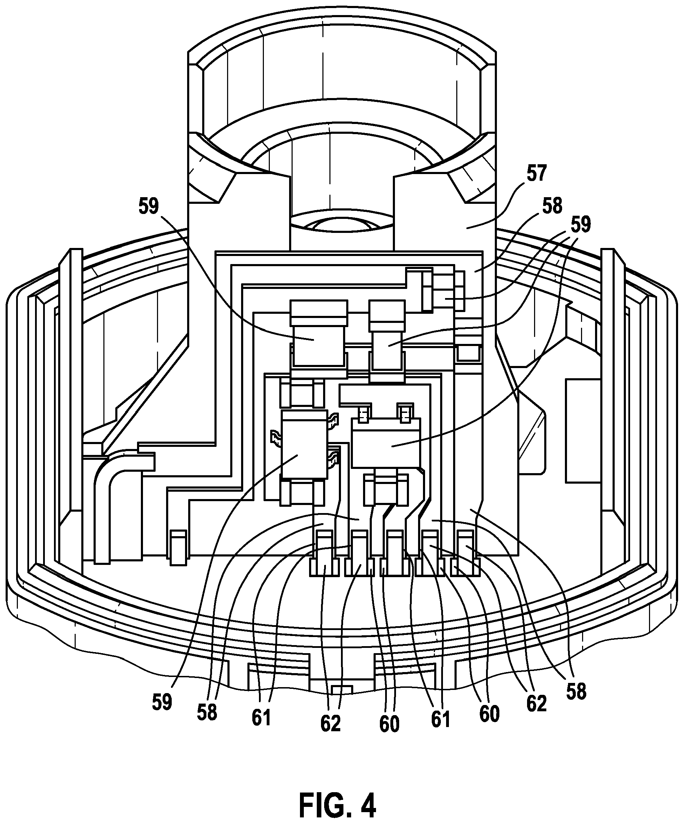

Figur 4 zeigt eine Draufsicht auf die Schaltungsfläche 57. An die Schaltungsfläche 57 schließt sich der Verbindungsabschnitt 53 an, in den Stanzgitterleitungen 62 als Zuleitungen zu dem Antriebsmotor 2 eingebettet sind. Die Schaltungsfläche 57 steht im Wesentlichen senkrecht bzw. quer zu der Erstreckungsrichtung der Stanzgitterleitungen 62 ab. An der Position, an der die Schaltungsfläche 57 auf der Bürstenträgerbasis 55 aufsitzt, sind in dem Material der Kontaktierungskomponente 5 Öffnungen 60 vorgesehen, um dort die Stanzgitterleitungen 62 freizulegen. Die Leiterbahn 58 ist zu den Öffnungen 60 geführt. Die durch die SMD-Bauelemente 59 gebildete Schaltung wird nun durch die Öffnungen 60 mit den Stanzgitterleitungen 62 kontaktiert.

Wie in Figur 4 dargestellt, ist die Leiterbahn 58 mit an den Öffnungen 60 zugewandten Enden 61 versehen. Eine Kontaktierung der Stanzgitterleitungen 62 mit den Enden 61 der Leiterbahn 58 kann in einem Arbeitsschritt des leitfähigen Verklebens der Bauelemente 59 auf der Leiterbahn 58 vorgenommen werden. Dazu muss ein Klebepunkt aus leitfähigem Klebstoff in die Öffnungen 60 eingebracht werden, so dass sich der Klebepunkt von den Stanzgitterleitungen 62 bis zu den Enden 61 der Leiterbahn 58 erstreckt und dadurch eine elektrische Kontaktierung herstellt. Der Klebepunkt befindet sich dann in der Öffnung 60, kontaktiert den freiliegenden Abschnitt der betreffenden Stanzgitterleitung 62 und weist eine ausreichende Größe auf, um ebenfalls in elektrischen Kontakt mit dem Ende 61 der Leiterbahn 58 zu gelangen.

Durch das Vorsehen der SMD-Bauelemente 59 auf der Schaltungsfläche 57 kann ein Bauraum für bedrahtete Bauelemente bzw. für eine Leiterplatte, wie beispielsweise eine Entstörplatine, eingespart werden. Durch die geringe Bauhöhe der SMD-Bauelemente 59 ist das Vorsehen von zusätzlichem Bauraum zum Einbringen der Bauelemente 59 in der Regel nicht notwendig, so dass das gesamte Antriebsmodul 1 Platz sparend aufgebaut werden kann. Zudem sind verbesserte elektrische Eigenschaften zu erwarten, da die Bauelemente 59 mit kürzerer Anbindung an die Stanzgitterleitungen 62 angeschlossen werden können.

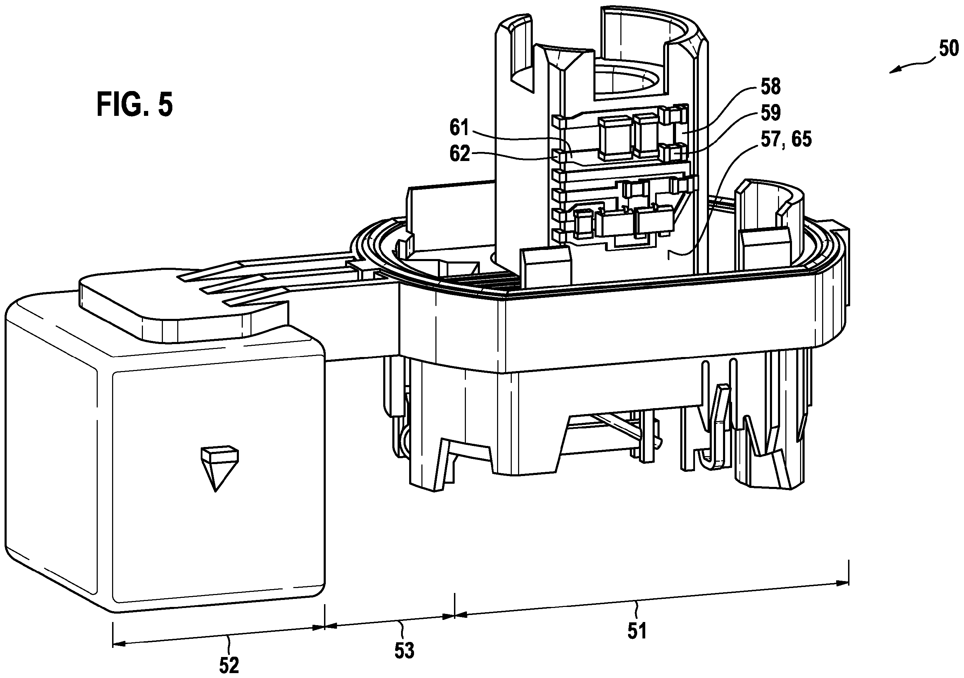

Eine weitere Kontaktierungskomponente 50 ist in Figur 5 separat dargestellt. Die Kontaktierungskomponente 50 weist wie bei der obigen Ausführungsform einen Antriebsmodulabschnitt 51 und einen Steckverbinderabschnitt 52 auf, die über einen Verbindungsabschnitt 53 miteinander verbunden sind. Im Unterschied ist jedoch die Schaltungsfläche 57 nicht quer, sondern parallel zur Erstreckungsrichtung der Stanzgitterleitungen 62 angeordnet, wobei die Leiterbahn 58 sich auf eine Zuleitungsfläche 65 erstreckt, die als Teil der Schaltungsfläche quer zur Erstreckungsrichtung der Stanzgitterleitungen 62 verläuft, so dass eine Kontaktierung mit den Stanzgitterleitungen 62 in der oben beschriebenen Weise erfolgen kann.

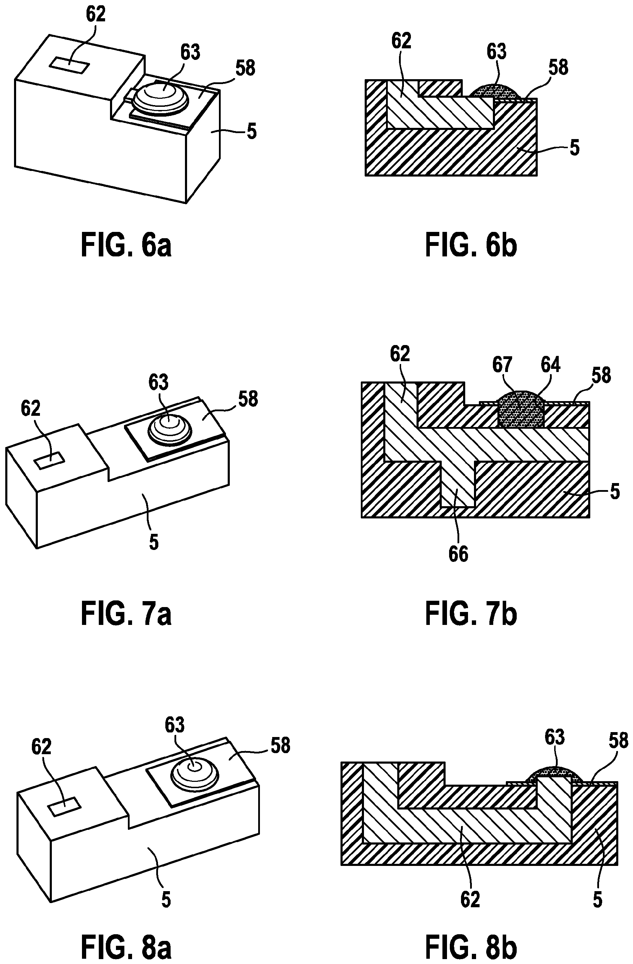

In den Figuren 6a - 6b ist eine perspektivische und Querschnittsdarstellung durch eine weitere Ausgestaltung des Verbindungsbereichs zwischen einer der Stanzgitterleitungen 62 und der Leiterbahn 58 dargestellt. In der gezeigten Ausführungsform ist dargestellt, dass die Stanzgitterleitung 62 an die Leiterbahn 58 herangeführt ist und an diese angrenzt. Durch Aufbringen eines leitfähigen Klebepunkts 63, der sich über einen Teil der Leiterbahn 58 und einen Teil der Stanzgitterleitung 62 erstreckt, kann eine elektrische Verbindung hergestellt werden.

In den Figuren 7a und 7b ist eine perspektivische und Querschnittsdarstellung durch den Verbindungsbereich zwischen einer der Stanzgitterleitungen 62 und der Leiterbahn 58 in einer weiteren Variante dargestellt. In der gezeigten Ausführungsform ist eine Ausnehmung 64 vorgesehen, wobei an der Oberfläche, an der die Ausnehmung 64 vorgesehen ist, sich die Leiterbahn 58 befindet. Insbesondere kann die Ausnehmung 64 die Leiterbahn 58 durchdringen. Durch Einbringen eines Klebetropfens 67, der die Ausnehmung 64 vollständig ausfüllt, kann die elektrische Verbindung hergestellt werden. Um die Verbindung mit dem leitfähigen Klebstoff thermisch zu entlasten, kann die Stanzgitterleitung 62 eine abzweigende bzw. abstehende Struktur 66 aufweisen, durch die thermische Spannungen reduziert werden.

In den Figuren 8a und 8b ist eine perspektivische und Querschnittsdarstellung durch den Verbindungsbereich zwischen einer der Stanzgitterleitungen 62 und der Leiterbahn 58 in einer weiteren Variante dargestellt. In der gezeigten Ausführungsform ist dargestellt, dass eine der Stanzgitterleitungen 62 aus dem Körper der Kontaktierungskomponente 5 herausragt und die Leiterbahn 58 um den herausragenden Abschnitt der Stanzgitterleitung 62 angeordnet ist. Durch Aufbringen des leitfähigen Klebstoffs auf den herausragenden Abschnitt der Stanzgitterleitung 62 kann eine elektrische Verbindung zwischen der Stanzgitterleitung 62 und der Leiterbahn 58 hergestellt werden.

## Patentansprüche

1. Kontaktierungskomponente (5) - insbesondere ein Bürstenhalterbauteil - für ein Antriebsmodul (1), umfassend:
- einen Grundkörper zum Bereitstellen einer Kontaktierung eines bürstenkommutierten Antriebsmotors (2) über Bürsten;
- mindestens eine Zuleitung (62), insbesondere eine Stanzgitterleitung, zum elektrischen Kontaktieren des Antriebsmotors (2);
- eine Schaltungsfläche (57), auf der mittels einer MID-Technik eine Leiterbahn (58) unmittelbar aufgebracht ist; und
- mindestens ein Bauelement (59), insbesondere ein SMD-Bauelement (59), das mit der Leiterbahn (58) elektrisch verbunden ist wobei der Grundkörper einen Antriebsmodulabschnitt (51) und einen Steckverbinderabschnitt (52) aufweist, die über einen Verbindungsabschnitt (53) miteinander verbunden sind, und der Grundkörper einstückig aus einem Kunststoffmaterial hergestellt ist, und der Antriebsmodulabschnitt (51) einen ersten Halteabschnitt (54) mit Haltestrukturen
aufweist, die in ein Polgehäuse (21) einsetzbar sind, so dass die Kontaktierungskomponente (5) fest auf dem Polgehäuse (21) des Antriebsmotors (2) aufsitzt, wobei in dem ersten Halteabschnitt (54) der Kontaktierungskomponente (5) die Bürsten in entsprechenden Bürstenträgern angeordnet sind, wobei sich an den ersten Halteabschnitt (54) eine Bürstenträgerbasis (55) des Grundkörpers der Kontaktierungskomponente (5) anschließt, und an der dem ersten Halteabschnitt (54) gegenüberliegenden Seite der Bürstenträgerbasis (55) ein zweiter Halteabschnitt (56) mit entsprechenden Haltestrukturen vorgesehen ist, die im montierten Zustand in
ein Getriebegehäuse (3) hineinragen und dadurch die Kontaktierungskomponente (5) mit dem Getriebegehäuse (3)
verbinden, wobei die Schaltungsfläche (57) in das Getriebegehäuse (3)
hineinragt, wobei der zweite Halteabschnitt (56) des Grundkörpers die Schaltungsfläche (57) aufweist, wobei auf die Schaltungsfläche (57) die Leiterbahn (58) direkt auf die Oberfläche des Materials des Grundkörpers aufgebracht ist, und
wobei das mindestens eine Bauelement (59) einen Hallsensor umfasst, der so an der Schaltungsfläche (57) angeordnet ist, dass er im
montierten Zustand der
Kontaktierungskomponente (5) in einer Richtung senkrecht zur Richtung
einer Motorwelle einem Ringmagneten an der Motorwelle
gegenüberliegt.

2. Kontaktierungskomponente (5) nach Anspruch 1, wobei die mindestens eine Zuleitung (62) zumindest abschnittsweise in einer Erstreckungsrichtung verläuft, wobei die Schaltungsfläche (57) quer zur Erstreckungsrichtung angeordnet ist.

3. Kontaktierungskomponente (5) nach Anspruch 1, wobei die mindestens eine Zuleitung (62) zumindest abschnittsweise in einer Erstreckungsrichtung verläuft, wobei die Schaltungsfläche (57) parallel zur Erstreckungsrichtung angeordnet ist und wobei die Leiterbahn (58) zur Kontaktierung der mindestens einen Zuleitung (62) auf eine benachbarte Zuleitungsfläche (65) geführt wird, die quer zur Erstreckungsrichtung angeordnet ist.

4. Kontaktierungskomponente (5) nach Anspruch 2 oder 3, wobei das Bauelement (59) mit der Leiterbahn (58) und/oder die Leiterbahn (58) mit der mindestens einen Zuleitung (62) verbunden ist, indem ein leitfähiges Material, insbesondere ein leitfähiger Klebstoff oder ein Lotmaterial zwischen einen Kontakt des Bauelements (59) und die Leiterbahn (58) bzw. zwischen die mindestens eine Zuleitung (62) und die Leiterbahn (58) aufgebracht wird.

5. Kontaktierungskomponente (5) nach Anspruch 4,
wobei ein Abschnitt der Zuleitung (62) über eine Öffnung (64) nahe einem Ende (61) der zu kontaktierenden Leiterbahn (58) zugänglich ist, oder wobei ein Abschnitt der Zuleitung (62) die zu kontaktierende Leiterbahn (58) durchdringt oder
wobei ein Abschnitt der Zuleitung (62) an einer Oberfläche der Kontaktierungskomponente (5) geführt ist und die Leiterbahn (58) an den Abschnitt der Zuleitung (62) angrenzt.

6. Kontaktierungskomponente (5) nach einem der vorhergehenden Ansprüche, wobei die der Grundkörper einen Durchbruch zur Aufnahme einer Rotorwelle eines Antriebsmotors (2) und einen elektrische Pins aufnehmenden Anschluss-Stecker (52) aufweist, und die Erstreckungsrichtung der mindestens eine Zuleitung (62) mit den Pins verbunden ist - und insbesondere die Erstreckungsrichtung in radialer Richtung zur Rotorwelle verläuft.

7. Antriebsmodul (1) umfassend:
- einen Antriebsmotor (2);
- eine Kontaktierungskomponente (5) nach Anspruch 1 bis 6, die mit dem Antriebsmotor (2) verbunden ist, um eine Kontaktierung des Antriebsmotors (2) über die Zuleitungen (62) bereitzustellen.

8. Antriebsmodul (1) nach Anspruch 7, wobei das Antriebsmodul (1) in das Polgehäuse (21) des Antriebsmotors (2) eingesetzt ist.

9. Antriebsmodul (1) nach Anspruch 7 oder 8, wobei an einer dem Antriebsmotor (2) gegenüberliegenden Seite der Kontaktierungskomponente (5) ein Getriebegehäuse (3) angeordnet ist, wobei die Schaltungsfläche (57) in das Getriebegehäuse (3) hineinragt.

10. Verfahren zum Herstellen einer Kontaktierungskomponente (5) für ein Antriebsmodul (1) **nach einem der Ansprüche 1 - 6,** mit folgenden Schritten:
- Bereitstellen eines **einstückigen, nicht leitenden** Grundkörpers aus einem Kunststoffmaterial, mit mindestens einer zumindest teilweise eingebetteten Zuleitung (62) zum Bereitstellen einer Kontaktierung eines bürstenkommutierten Antriebsmotors (2);
- Aufbringen einer Leiterbahn (58) unmittelbar auf eine Schaltungsfläche (57) direkt auf die Oberfläche des Materials des Grundkörpers mittels einer MID-Technik; und
- elektrisches Kontaktieren mindestens eines elektrischen Bauelements (59), insbesondere eines SMD-Bauelements (59), über die Leiterbahn (58).

11. Verfahren nach Anspruch 10, wobei das elektrische Bauelement (59) mittels eines aushärtenden leitfähigen Materials, insbesondere eines leitfähigen Klebstoffes, oder mit einer Lötverbindung elektrisch kontaktiert wird.

12. Verfahren nach Anspruch 11, wobei eine elektrische Verbindung zwischen der mindestens einen Zuleitung (62) und der Leiterbahn (58) durch Aufbringen des aushärtenden leitfähigen Materials erfolgt.

13. Verfahren nach Anspruch 12, wobei die Leiterbahn (58) durch eines der folgenden Verfahren zur MID-Technik auf die Schaltungsfläche (57) aufgebracht wird:
- Bedrucken mit einer Folie aus einem leitfähigen Material unter Verwendung eines Heißprägestempels, der die Strukturen der Leiterbahn (58) als Prägeflächen abbildet, so dass der mit dem Heißprägestempel beaufschlagte Bereich der Folie mit dem Material des Grundkörpers verschmilzt und beim Abziehen der Folie an dem Grundkörper haften bleibt, während der übrige Bereich der Folie sich von der Schaltungsfläche (57) löst;
- Besprühen der Schaltungsfläche (57) durch eine Strukturierungsmaske mit leitfähigen Metallpartikeln, die haftend ausgebildet sind, so dass die Struktur der Leiterbahn (58) entsprechend der Strukturierungsmaske auf der Schaltungsfläche ausgebildet wird;
- Beschreiben der Schaltungsfläche (57) mithilfe einer Laser-Direktstrukturierung entsprechend der Struktur der Leiterbahn (58), so dass das Material des Grundkörpers im Bereich der aufzubringenden Leiterbahn (58) aktiviert wird, wobei die Leiterbahn (58) durch galvanisches Metallisieren des aktivierten Bereichs hergestellt wird.

## Claims

1. Contacting part (5) - in particular a brush holder component - for a drive module (1), comprising:
- a basic body for providing contacting of a brush-commutated drive motor (2) via brushes;
- at least one supply line (62), in particular a leadframe line, for electrically contacting the drive motor (2);
- a circuit surface (57) on which a strip conductor (58) is directly applied by means of an MID technique; and
- at least one component (59), in particular an SMD component (59), which is electrically connected to the strip conductor (58),
wherein the basic body has a drive module portion (51) and a connector portion (52) which are connected to each other via a connection portion (53), and the basic body is produced as a single piece from a plastics material, and the drive module portion (51) has a first holding portion (54) with holding structures which can be inserted into a stator (21) such that the contacting part (5) sits fixedly on the stator (21) of the drive motor (2), wherein, in the first holding portion (54) of the contacting part (5), the brushes are arranged in corresponding brush supports, wherein the first holding portion (54) is adjoined by a brush support base (55) of the basic body of the contacting part (5), and on that side of the brush support base (55) which is situated opposite the first holding portion (54), a second holding portion (56) with corresponding holding structures is provided, the holding structures, in the fitted state, projecting into a transmission case (3) and thereby connecting the contacting part (5) to the transmission case (3), wherein the circuit surface (57) projects into the transmission case (3), wherein, the second holding portion (56) of the basic body has the circuit surface (57), wherein, on the circuit surface (57), the strip conductor (58) is applied directly onto the surface of the material of the basic body, and wherein the at least one component (59) comprises a Hall sensor, which is arranged on the circuit surface (57) in such a manner that, in the fitted state of the contacting part (5), it is situated opposite a ring magnet on the motor shaft in a direction perpendicular to the direction of a motor shaft.

2. Contacting part (5) according to Claim 1, wherein the at least one supply line (62) runs at least in sections in one direction of extent, wherein the circuit surface (57) is arranged transversely with respect to the direction of extent.

3. Contacting part (5) according to Claim 1, wherein the at least one supply line (62) runs at least in sections in one direction of extent, wherein the circuit surface (57) is arranged parallel to the direction of extent, and wherein, for contacting the at least one supply line (62), the strip conductor (58) is guided onto an adjacent supply line surface (65) which is arranged transversely with respect to the direction of extent.

4. Contacting part (5) according to Claim 2 or 3, wherein the component (59) is connected to the strip conductor (58) and/or the strip conductor (58) is connected to the at least one supply line (62) by a conductive material, in particular a conductive adhesive or a solder material, being applied between the contact of the component (59) and the strip conductor (58) or between the at least one supply line (62) and the strip conductor (58).

5. Contacting part (5) according to Claim 4, wherein a portion of the supply line (62) is accessible via an opening (64) close to one end (61) of the strip conductor (58) to be contacted, or wherein a portion of the supply line (62) penetrates the strip conductor (58) to be contacted, or wherein a portion of the supply line (62) is guided on a surface of the contacting part (5) and the strip conductor (58) is adjacent to the portion of the supply line (62).

6. Contacting part (5) according to one of the preceding claims, wherein the the basic body has an aperture for receiving a rotor shaft of a drive motor (2) and a connection plug (52) receiving electric pins, and the direction of extent of the at least one supply line (62) is connected to the pins - and in particular the direction of extent runs in the radial direction with respect to the rotor shaft.

7. Drive module (1) comprising:
- a drive motor (2);
- a contacting part (5) according to Claim 1 to 6 which is connected to the drive motor (2) in order to provide contacting of the drive motor (2) via the supply lines (62).

8. Drive module (1) according to Claim 7, wherein the drive module (1) is inserted into the stator (21) of the drive motor (2).

9. Drive module (1) according to Claim 7 or 8, wherein a transmission case (3) is arranged on a side of the contacting part (5) that is situated opposite the drive motor (2), wherein the circuit surface (57) projects into the transmission case (3).

10. Method for producing a contacting part (5) for a drive module (1) according to one of Claims 1-6, with the following steps:
- providing a single-piece, non-conductive basic body made from a plastics material, with at least one at least partially embedded supply line (62) for providing contacting of a brush-commutated drive motor (2);
- applying a strip conductor (58) directly onto a circuit surface (57) directly onto the surface of the material of the basic body by means of an MID technique; and
- electrically contacting at least one electric component (59), in particular an SMD component (59), via the strip conductor (58).

11. Method according to Claim 10, wherein the electric component (59) is electrically contacted by means of a curing conductive material, in particular a conductive adhesive, or with a soldered joint.

12. Method according to Claim 11, wherein an electric connection between the at least one supply line (62) and the strip conductor (58) is undertaken by applying the curing conductive material.

13. Method according to Claim 12, wherein the strip conductor (58) is applied to the circuit surface (57) by one of the following methods for the MID technique:
- printing with a film made from a conductive material using a hot embossing die which depicts the structures of the strip conductor (58) as embossed surfaces such that that region of the film which is acted upon by the hot embossing die fuses with the material of the basic body and remains adhering to the basic body when the film is peeled off, while the remaining region of the film is detached from the circuit surface (57);
- spraying the circuit surface (57) through a patterning mask with conductive metal particles which are formed so as to adhere such that the structure of the strip conductor (58) is formed on the circuit surface in a manner corresponding to the patterning mask;
- inscribing the circuit surface (57) with the aid of laser direct patterning in accordance with the structure of the strip conductor (58) such that the material of the basic body is activated in the region of the strip conductor (58) to be applied, wherein the strip conductor (58) is produced by electrodeposition metallization of the activated region.

## Revendications

1. Pièce de contact (5) - en particulier un élément porte-balais - pour un module d'entraînement (1), comprenant :
- un corps de base pour fournir un contact d'un moteur d'entraînement à commutation à balais (2) par le biais de balais ;
- au moins une ligne d'alimentation (62), en particulier une ligne à grille estampée, pour le contact électrique du moteur d'entraînement (2) ;
- une surface de circuit (57) sur laquelle une piste conductrice (58) peut être appliquée directement au moyen d'une technique MID ; et
- au moins un composant (59), en particulier un composant SMD (59), qui est connecté électriquement à la piste conductrice (58), le corps de base présentant une portion de module d'entraînement (51) et une portion de connecteur enfichable (52) qui sont connectées l'une à l'autre par le biais d'une portion de connexion (53), et le corps de base étant fabriqué d'une seule pièce à partir d'une matière plastique, et la portion de module d'entraînement (51) présentant une première portion de retenue (54) avec des structures de retenue qui peuvent être insérées dans un boîtier polaire (21) de telle sorte que la pièce de contact (5) repose fixement sur le boîtier polaire (21) du moteur d'entraînement (2), les balais étant disposés dans des supports de balais correspondants dans la première portion de retenue (54) de la pièce de contact (5), une base de support de balai (55) du corps de base de la pièce de contact (5) se raccordant à la première portion de retenue (54), et une deuxième portion de retenue (56) avec des structures de retenue correspondantes étant prévue au niveau du côté de la base de support de balais (55) opposé à la première portion de retenue (54), lesquelles structures de retenue pénètrent dans l'état monté dans un boîtier de transmission (3) et relient de ce fait la pièce de contact (5) au boîtier de transmission (3), la surface de circuit (57) pénétrant dans le boîtier de transmission (3), la deuxième portion de retenue (56) du corps de base présentant la surface de circuit (57), la piste conductrice (58) sur la surface de circuit (57) étant appliquée directement sur la surface du matériau du corps de base, et l'au moins un composant (59) comprenant un capteur de hall qui est disposé sur la surface de circuit (57) de telle sorte que dans l'état monté de la pièce de contact (5), il soit opposé, dans une direction perpendiculaire à la direction d'un arbre de moteur, à un aimant annulaire sur l'arbre de moteur.

2. Pièce de contact (5) selon la revendication 1, dans laquelle l'au moins une ligne d'alimentation (62) s'étend au moins en partie dans une direction d'étendue, la surface de circuit (57) étant disposée transversalement par rapport à la direction d'étendue.

3. Pièce de contact (5) selon la revendication 1, dans laquelle l'au moins une ligne d'alimentation (62) s'étend au moins en partie dans une direction d'étendue, la surface de circuit (57) étant disposée parallèlement à la direction d'étendue et la piste conductrice (58), pour le contact de l'au moins une ligne d'alimentation (62), étant guidée sur une surface de ligne d'alimentation adjacente (65) qui est disposée transversalement par rapport à la direction d'étendue.

4. Pièce de contact (5) selon la revendication 2 ou 3, dans laquelle le composant (59) est connecté à la piste conductrice (58) et/ou la piste conductrice (58) est connectée à l'au moins une ligne d'alimentation (62), par le fait qu'un matériau conducteur, en particulier un adhésif conducteur ou un matériau de brasage, est appliqué entre un contact du composant (59) et la piste conductrice (58) ou entre l'au moins une ligne d'alimentation (62) et la piste conductrice (58).

5. Pièce de contact (5) selon la revendication 4, dans laquelle une portion de la ligne d'alimentation (62) est accessible par le biais d'une ouverture (64) à proximité d'une extrémité (61) de la piste conductrice (58) à mettre en contact, ou une portion de la ligne d'alimentation (62) traverse la piste conductrice (58) à mettre en contact ou
une portion de la ligne d'alimentation (62) est guidée sur une surface de la pièce de contact (5) et la piste conductrice (58) est adjacente à la portion de la ligne d'alimentation (62).

6. Pièce de contact (5) selon l'une quelconque des revendications précédentes, dans laquelle le le corps de base présente un orifice pour recevoir un arbre de rotor d'un moteur d'entraînement (2) et un connecteur de raccordement (52) recevant des broches électriques, et la direction d'étendue de l'au moins une ligne d'alimentation (62) est associée aux broches et notamment la direction d'étendue s'étend dans la direction radiale par rapport à l'arbre de rotor.

7. Module d'entraînement (1), comprenant :
- un moteur d'entraînement (2) ;
- une pièce de contact (5) selon les revendications 1 à 6, qui est connectée au moteur d'entraînement (2) afin de fournir un contact du moteur d'entraînement (2) par le biais des lignes d'alimentation (62).

8. Module d'entraînement (1) selon la revendication 7, dans lequel le module d'entraînement (1) est inséré dans le boîtier polaire (21) du moteur d'entraînement (2).

9. Module d'entraînement (1) selon la revendication 7 ou 8, dans lequel un boîtier de transmission (3) est disposé au niveau d'un côté de la pièce, de contact (5) opposé au moteur d'entraînement (2), la surface de circuit (57) pénétrant dans le boîtier de transmission (3).

10. Procédé de fabrication d'une pièce de contact (5) pour un module d'entraînement (1) selon l'une quelconque des revendications 1 à 6, comprenant les étapes suivantes :
- fournir un corps de base d'une seule pièce, non conducteur, en matière plastique, comprenant au moins une ligne d'alimentation (62) au moins en partie encastrée pour fournir un contact avec un moteur d'entraînement (2) à commutation à balais ;
- application d'une piste conductrice (58) directement sur une surface de circuit (57) directement sur la surface du matériau du corps de base au moyen d'une technique MID ; et
- mise en contact électrique d'au moins un composant électrique (59), en particulier d'un composant SMD (59), par le biais de la piste conductrice (58).

11. Procédé selon la revendication 10, dans lequel le composant électrique (59) est mis en contact électrique au moyen d'un matériau durcissable conducteur, en particulier d'un adhésif conducteur ou d'une connexion par brasage.

12. Procédé selon la revendication 11, dans laquelle une connexion électrique entre l'au moins une ligne d'alimentation (62) et la piste conductrice (58) est effectuée par application du matériau durcissable conducteur.

13. Procédé selon la revendication 12, dans lequel la piste conductrice (58) est appliquée par l'un des procédés suivants des techniques MID sur la surface de circuit (57) :
- impression avec un film constitué d'un matériau conducteur en utilisant un poinçon d'estampage à chaud, qui reproduit les structures de la piste conductrice (58) sous forme de surfaces estampées, de telle sorte que la région du film sollicitée avec le poinçon d'estampage à chaud fonde avec le matériau du corps de base et, lors du retrait du film, reste en adhérence sur le corps de base tandis que le reste de la région du film se détache de la surface de circuit (57) ;
- pulvérisation de la surface de circuit (57) à travers un masque de structuration avec des particules métalliques conductrices, qui sont réalisées de manière à adhérer de telle sorte que la structure de la piste conductrice (58) soit réalisée en fonction du masque de structuration sur la surface de circuit ;
- définition de la surface de circuit (57) à l'aide d'une structuration directe au laser de manière correspondant à la structure de la piste conductrice (58) de telle sorte que le matériau du corps de base dans la ' région de la piste conductrice (58) à appliquer soit activé, la piste conductrice (58) étant fabriquée par métallisation galvanique de la région activée.
